(19) Europäisches Patentamt
European Patent Office
Office européen des brevets

(11) **EP 2 333 779 A1**

(12) **EUROPEAN PATENT APPLICATION**

(43) Date of publication:
**15.06.2011 Bulletin 2011/24**

(51) Int Cl.:
*G11C 11/404* (2006.01)   *H01L 27/108* (2006.01)
*H01L 29/423* (2006.01)   *H01L 29/78* (2006.01)

(21) Application number: **10187012.9**

(22) Date of filing: **08.10.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **08.12.2009 FR 0958749**

(71) Applicant: **S.O.I.Tec Silicon on Insulator
Technologies
38190 Bernin (FR)**

(72) Inventors:
• **Mazure, Carlos
38190, BERNIN (FR)**
• **Ferrant, Richard
29770, ESQUIBIEN (FR)**

(74) Representative: **Collin, Jérôme et al
Cabinet Régimbeau
20, rue de Chazelles
75847 Paris Cedex 17 (FR)**

(54) **Method of controlling a SeOI dram memory cell having a second control gate buried under the insulating layer**

(57)    The invention relates to a method of controlling a DRAM memory cell consisting of an FET transistor on a semiconductor-on-insulator substrate comprising a thin film (3) of semiconductor material separated from a base substrate (1) by an insulating layer (2, BOX), the transistor having a channel (4) and two control gates, a front control gate (8, 11) being arranged on top of the channel (4) and separated from the latter by a gate dielectric (7, 10) and a back control gate (9, 12, 13, 17, 18) being arranged in the base substrate and separated from the channel (4) by the insulating layer (BOX), characterized in that, in a cell programming operation, the front control gate and the back control gate are used jointly by applying a first voltage to the front control gate and a second voltage to the back control gate, said first voltage being lower in amplitude than the voltage needed to program the cell when no voltage is applied to the back control gate.

**FIG. 2a**

**(Cont. next page)**

EP 2 333 779 A1

# FIG. 2b

## Description

### FIELD OF THE INVENTION

The field of the invention is that of semiconductor devices, and more particularly that of memory devices comprising a plurality of memory cells.

The invention relates more particularly to a method of controlling a DRAM (Dynamic Random Access Memory) type memory cell on a semiconductor-on-insulator (SeOI) substrate.

### BACKGROUND OF THE INVENTION

A conventional DRAM memory cell is formed by the combination of a transistor and a capacitor to store charges.

More recently, a DRAM memory cell consisting of just a transistor has been proposed. This cell utilizes a floating channel effect to store the charges and requires no additional capacitor.

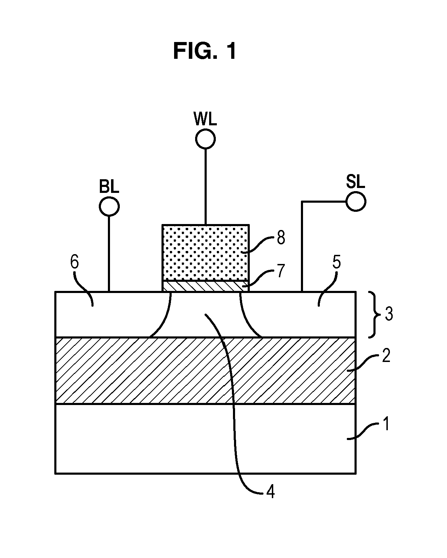

Figure 1 shows a cross-sectional view of such a floating channel DRAM memory cell. The floating channel DRAM cell is formed in a silicon-on-insulator SOI substrate comprising a thin film of silicon 3 separated form the base substrate 1 by a buried insulating layer 2 (generally a layer of oxide, designated "buried oxide layer" or BOX). A source region 5 and a drain region 6 are formed in the thin film 3 on top of the BOX 2, a floating channel region 4 separating the source and drain regions. A gate dielectric layer 7 and a gate electrode 8 are sequentially deposited on top of the floating channel 4. The drain region 6 is connected to a bit line BL, the source region 5 is connected to a source line SL and the gate electrode 8 is connected to a word line WL.

The floating channel is electrically isolated by the BOX, the gate dielectric layer, the source region and the drain region. Because of this isolation, the floating channel can store an electric charge.

In a data write operation in such a transistor, the floating body uses an impact ionization phenomenon to store charges, thereby modifying the threshold voltage of the transistor. In a data read operation, the quantity of current flowing between the source and the drain of the transistor then depends on the quantity of charges stored in the floating body.

The abovementioned DRAM cells offer the advantage of exhibiting a body effect which is characteristic of devices on SeOI and consists in storing charges, thereby modifying the threshold voltage of the transistor. In order to utilize this effect, it is necessary to apply an overvoltage to the gate electrode (via the word line WL). Thus, in order to be able to perform a logic 1 state write operation, a voltage greater than Vdd is typically applied, where Vdd corresponds to a nominal power supply voltage of the device. This overvoltage increases the current of the device and results in the impact ionization phenomenon which in turn creates the charges that will be stored under the channel, in the floating body.

It will be understood that the transistor is then stressed by this overvoltage. It is thus common practice to use relatively large transistors able to withstand such a stress.

Now, an ongoing objective in the field of application of the invention is that of miniaturization. It will therefore be understood that there is a need for a solution allowing for the use of smaller transistors in DRAM memory cells.

### BRIEF DESCRIPTION OF THE INVENTION

The aim of the invention is to meet this need, and, to this end, provides a method of controlling a DRAM memory cell consisting of an FET transistor on a semiconductor-on-insulator substrate comprising a thin film of semiconductor material separated from a base substrate by an insulating layer, the transistor having a channel and two control gates, a front control gate being arranged on top of the channel and separated from the latter by a gate dielectric and a back control gate being arranged in the base substrate and separated from the channel by the insulating layer, characterized in that, in a cell programming operation, the front control gate and the back control gate are used jointly by applying a first voltage to the front control gate and a second voltage to the back control gate, said first voltage being lower in amplitude than the voltage needed to program the cell when no voltage is applied to the back control gate.

Some preferred, but non-limiting, aspects of this method are as follows:

- the second voltage is positive;
- in a cell hold operation, a third voltage is applied to the back control gate;
- the third voltage is negative or zero;
- in a cell read operation, a fourth voltage is applied to the back control gate;
- the fourth voltage is positive;
- the front control gate and the back control gate are connected together and a voltage that is identical to the voltage applied to the back control gate is applied to the front control gate.

### BRIEF DESCRIPTION OF THE DRAWINGS

Other aspects, aims and advantages of the present invention will become more apparent from reading the following detailed description of preferred embodiments of the latter, given as non-limiting examples and with reference to the appended drawings in which:-

- Figure 1, already mentioned previously, represents a conventional floating body DRAM cell;
- Figure 2a represents a floating channel DRAM memory cell on SeOI intended for use in the method according to the first aspect of the invention;

- Figure 2b represents a floating channel DRAM memory cell on SeOI intended for use in the method according to the first aspect of the invention, on a cross section perpendicular to Figure 2a;
- Figure 3 represents a floating channel DRAM memory cell on SeOI of RCAT type intended for use in the method according to the first aspect of the invention;
- Figures 4a-4k illustrate different steps in sequences for forming and isolating a back control gate in the base substrate.

DETAILED DESCRIPTION OF THE INVENTION

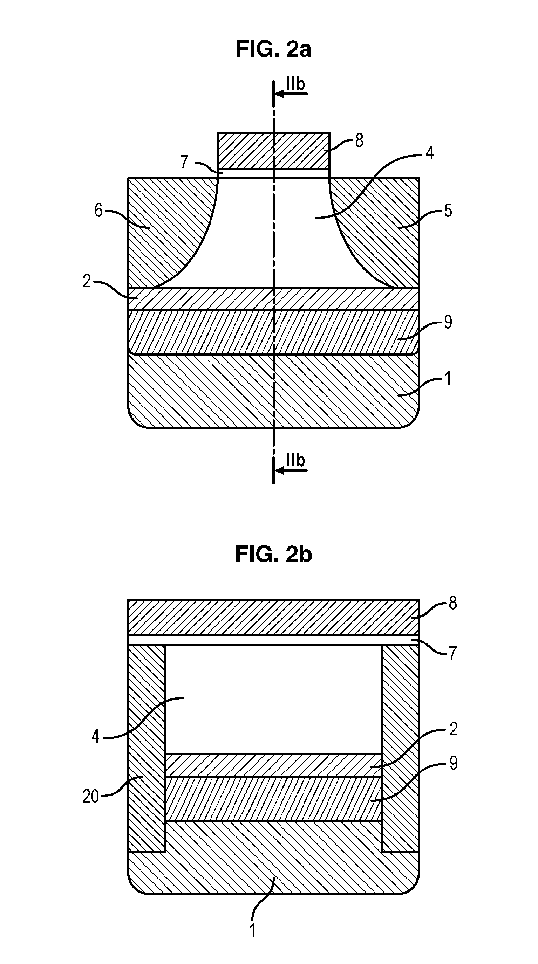

Referring to Figure 2a, a DRAM memory cell is represented that consists of a floating channel FET transistor on a semiconductor-on-insulator substrate comprising a thin film of semiconductive material separated from a base substrate 1 by an insulating layer 2, typically a buried oxide layer BOX.

The semiconductor-on-insulator substrate is, for example, a silicon-on-insulator SOI substrate.

According to a preferred embodiment, the insulating layer is a layer of $SiO_2$. According to an advantageous variant, the insulating layer comprises a dielectric layer (for example of silicon nitride, $Si_3N_4$) which can be sandwiched between two layers of $SiO_2$.

The transistor comprises, in the thin film, a source region 5, a drain region 6 and a floating channel 4 separating the source region from the drain region.

In this figure 2a, the drain D and the source S are in contact with the buried oxide layer BOX so that the body of the FET transistor is totally isolated from the adjacent cells and consequently floating.

The source S can thus be shared between two adjacent memory cells. Such sharing makes it possible to reduce the surface area occupied by a memory cell.

Figure 2b shows a cross section perpendicular to Figure 2a along the axis IIb-IIb in Figure 2a. While figure 2a represents, for example, a cross-sectional view on a line of the memory array, figure 2b represents a cross-sectional view along a column of the memory array.

Figure 2b illustrates the isolation of the body of the transistor (from the transistors along the same column) via lateral isolation trenches (using the STI, shallow trench isolation, technique) extending depthwise from the surface of the substrate at least as far as the insulating layer 2, even passing through this insulating layer so as to separate the wells, which will be described later and in which the back control gates are formed.

It will be understood that the invention is not limited to a fully depleted memory cell but also extends to a partially-depleted memory cell on SeOI. In a manner that is conventionally known per se, it is then also necessary to isolate the cells along a line of the memory array in order to isolate the channels of adjacent cells from one another. This is conventionally done using lateral isolation trenches of STI type extending depthwise from the surface of the substrate at least as far as the insulating layer, or passing through this insulating layer so as to separate the wells, which will be described later and in which the back control gates are formed.

The memory cell also comprises a front control gate 8 extending on the surface of the substrate on top of the channel 4. The front control gate 8 is isolated from the floating channel by means of a gate dielectric layer 7.

The memory cell also comprises a back control gate 9 arranged in the base substrate 1 and separated from the floating channel 4 by the insulating layer 2.

The memory cell thus has two control gates: the front control gate 8 that is conventionally used and the back control gate 9 which is provided by the invention and is notably intended for use jointly with the front control gate to perform a cell programming operation.

As a purely illustrative example, the thickness of the thin film of the semiconductor-on-insulator substrate (body of the transistor) is between 1.5 nm and 50 nm, and the thickness of the insulating layer (BOX) is between 1.5 nm and 50 nm.

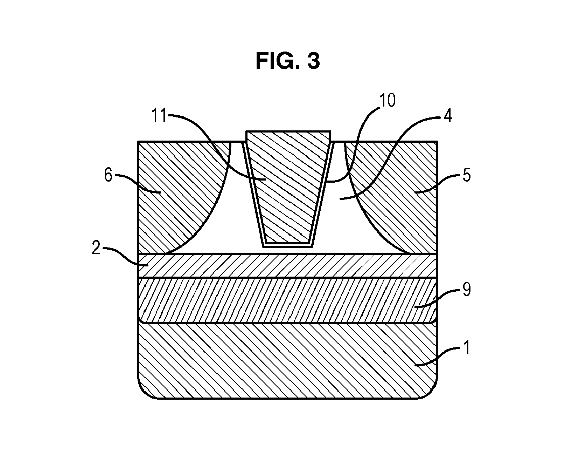

Figure 3 illustrates another possible embodiment of a fully depleted DRAM memory cell in accordance with the invention, in which the front control gate is not arranged on the surface of the substrate, but is, on the contrary, embedded in the floating channel. The front control gate 11 in this case fills a trench formed in the thickness of the channel 4, a gate dielectric layer 10 being arranged on the walls of the trench so as to isolate the gate 11 from the floating channel 4. An RCAT (Recessed Channel Array Transistor) type transistor is thus defined.

This second embodiment is advantageous in that the apparent width of the floating channel is then increased, making it possible in particular to counteract the undesirable electrical effects known by the acronym SCE (Short Channel Effects).

In the above, the example of a floating channel DRAM cell on SeOI has been taken. The invention does, however, also extend to a DRAM cell on SeOI produced by the combination of a transistor and a capacitor.

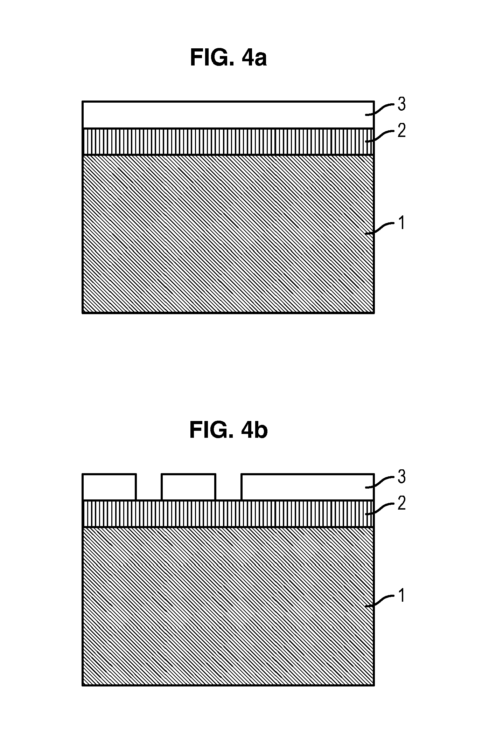

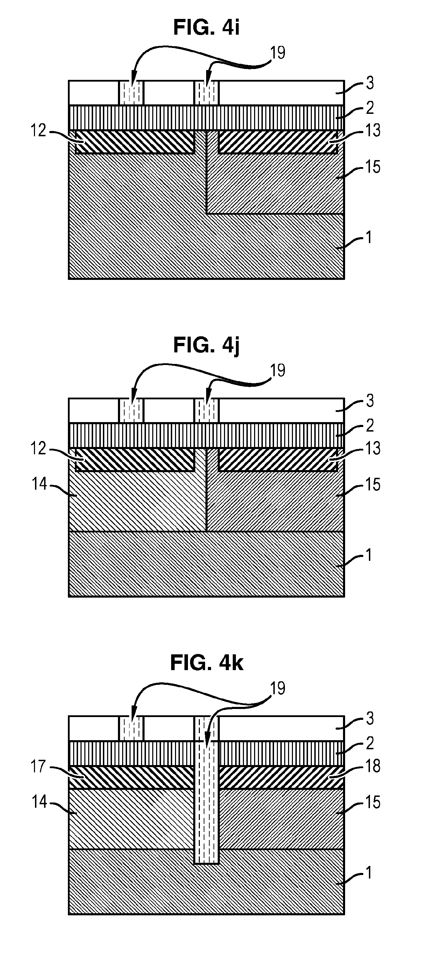

Figures 4a-4k illustrate different steps in the sequences for forming and isolating a back control gate in the base substrate. In these figures, the cases of a p-type and n-type back control gate are represented.

Figure 4a represents an SeOI substrate comprising a thin film of semiconductive material 3 separated from a base substrate 1 by an insulating layer 2.

In a first step, alignment marks are defined in the SeOI substrate so as to provide the necessary alignment in subsequent pattern masking and formation steps (formation of wells, back control gates, isolating structures, etc.).

This first substrate marking step thus consists in forming in the substrate a groove, a trench, a mesa or any other sign (such as a cross for example).

Figure 4b illustrates to this end the formation of mesas by etching of the surface layer. In order to do this, standard CMOS fabrication processes can be used.

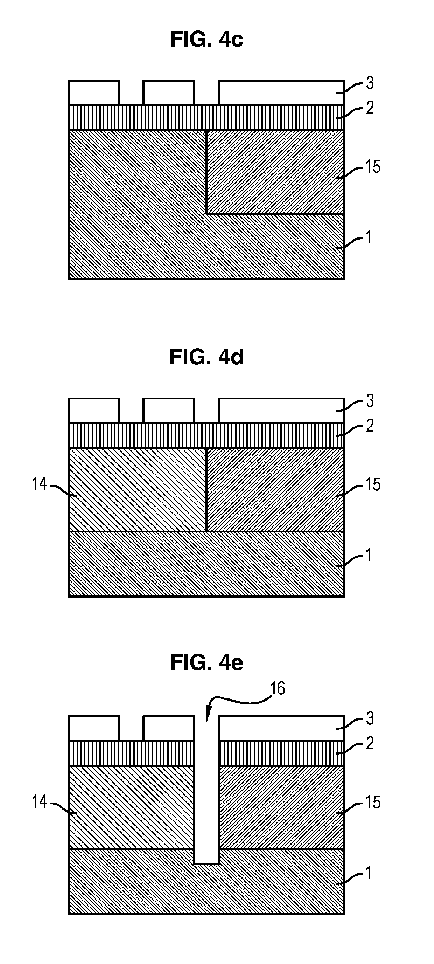

Referring to figures 4c, 4d and 4e, various possible approaches are represented for the formation of wells buried under the insulating layer BOX, the purpose of which is to ultimately ensure that one or more back control gates are isolated from the base substrate 1.

In each of figures 4c, 4d and 4e, the base substrate 1 is doped so as to exhibit, in a top layer the latter, an n-type conductivity. The doping level is typically between $1x10^{15}$ and $5x10^{16}$ cm$^{-3}$.

In figure 4c, a p-type well 15 has been produced, by dopant implantation, below the isolating layer 2 in the n-type base substrate 1. The p-type well 15 is thus isolated from the n-type substrate by a pn junction.

In figure 4d, both a p-type well 15 and an n-type well 14 have been produced. The wells 14, 15 are isolated from one another by a pn junction.

In figure 4e, both a p-type well 15 and an n-type well 14 have been produced, as in figure 4d. An STI-type isolating trench 16 has also been produced, extending depthwise, from the surface of the SeOI substrate, under the insulating layer BOX, into the base substrate 31, this trench providing isolation between the wells 14, 15.

The doping level in the wells of figures 4c, 4d and 4e is typically between $5x10^{16}$ and $5x10^{18}$ cm$^{-3}$.

It will be noted that the steps needed to fabricate the structures represented in figures 4c, 4d and 4e are based on standard CMOS fabrication processes.

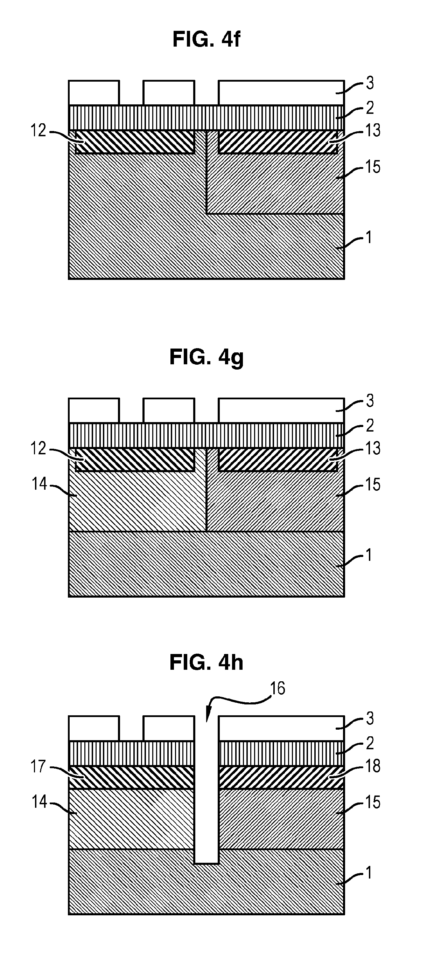

Starting from the structure represented in figure 4c (or figure 4d and figure 4e), a dopant implantation is then implemented in order to form the back control gates 12, 13, 17, 18 under the insulating layer 2 as represented in figure 4f (or figure 4g and figure 4h).

The doping level for the formation of a back control gate is typically between $5x10^{18}$ and $5x10^{20}$ cm$^{-3}$.

As represented in figures 4g and 4h, the back control gate 12, 13, 17, 18 is isolated from the base substrate 1 by a well 14, 15 of opposite bias (p-type well 15 for the n-type back control gate 13, 18; n-type well 14 for a p-type back control gate 12, 17).

In the case of figure 4f, a well has been produced only for a single back control gate bias (p-type well 13 isolates an n-type back control gate 13, while a p-type back control gate 12 is arranged directly in the n-biased base substrate 1).

It will be noted that, as a general rule, the well voltage is chosen so that the diode created by the electrical node between the back control gate and the well is always reversed, the diode then isolating the back control gate from the well and from anything that it might contain (other back control gates in particular).

According to a first embodiment represented in figure 4h, the back control gate 17, 18 extends under the entire width of the well 14, 15. In this particular case, the isolating trench 16 is used to isolate the back control gates 17, 18 from one another.

According to another embodiment represented in figure 4g, the back control gate 12, 13 is located so as to extend only over a portion of the width of the well 14, 15. It will be noted that an isolating trench can also be provided when the back control gate is localized by thus contributing to the isolation of the wells. According to a variant embodiment that is not represented, a second isolating layer, arranged in the base substrate below the BOX isolating layer, can contribute, wholly or partly, the isolation of a back control gate from the base substrate.

Starting from the structure represented in figure 4f (or figure 4g and figure 4h), the mesas and, where appropriate, the isolating trenches are then filled by the deposition of a dielectric. This filling implements standard side wall passivation, filling and surface planarization processing operations.

One or more transistors (of the same type) can then be formed in each of the regions of the thin film 3 delimited by the insulating regions 19 formed by the duly deposited dielectric.

In the context of the invention, the back control gate is used to dynamically modify the effective threshold voltage of the transistor. More particularly, the voltage that is applied to the back control gate is modulated according to the type of cell control operations (programming, erase, read, hold).

A transistor whose channel has an n-type conductivity and a back control gate of p-type conductivity (the back control gate is then said to have a work function) has a very high threshold voltage. This threshold voltage can then be reduced by applying a positive voltage to the back control gate.

A transistor whose channel has an n-type conductivity and a back control gate of n-conductivity (the back control gate is then said to have no work function) has a nominal threshold voltage that can be reduced by applying a positive voltage to the back control gate. This variation of the threshold voltage of the transistor via the back control gate can be formulated according to $V_{th} = V_{to} - \alpha V_{BG}$, in which $V_{th}$ represents the threshold voltage of the transistor, $V_{BG}$ the voltage applied to the back control gate, $V_{t0}$ the nominal threshold voltage (which can also be offset by the work function depending on whether an n- or p-type or metal back control gate is used), and $\alpha$ a coefficient linked to the architecture of the transistor.

As presented in the thesis entitled "Architectures innovantes de mémoire non-volatile embarquée sur film mince de silicium" (Innovative non-volatile memory architectures embedded in a thin silicon film) defended by Germain Bossu in June 2009 at the University of Provence Aix Marseille I, the coefficient $\alpha$ can in particular be approximated according to

$$\alpha = \frac{3.t_{ox1}}{t_{Si} + 3.t_{ox2}},$$

in which $t_{ox1}$ denotes the thickness of the gate dielectric layer separating the front control gate from the channel, $t_{ox2}$ denotes the thickness of the insulating layer separating the back control gate from the channel and $t_{si}$ denotes the thickness of the thin film.

It will therefore be understood that the type of doping of the back control gate associated with a transistor offsets or does not offset the nominal threshold voltage, and that the bias of the back control gate can be used to adjust the threshold voltage.

In the context of the invention, the bias of the back control gate 6 is preferentially chosen so that the back control gate does not have any work function. This bias must thus be of the same type as the FET transistor (in other words, an n-type bias for an n-type transistor, a p-type bias for a p-type transistor). The invention does, however, also extend to a back gate having a working voltage (bias opposite to that of the FET transistor).

Moreover, the invention is of course not limited to an n-type transistor, but also extends to a p-type transistor.

Returning to the general case of a back control gate, a positive voltage applied to the back control gate reduces the effective threshold voltage of the transistor.

The effective threshold voltage can also be increased via a negative voltage applied to the back control gate, thereby reducing the leakage currents, advantageously in an overall inactive state of the circuit.

In the context of the invention, the back control gate associated with a transistor of an SeOI DRAM cell is used dynamically: the voltage applied to it is effectively modulated according to the type of cell control operations (programming, erase, read, hold or retain).

The invention thus proposes jointly using the front control gate and the back control gate in a cell programming operation, by applying a first voltage to the front control gate and a second voltage to the back control gate, said first voltage being lower in amplitude than the voltage needed to program the cell when no voltage is applied to the back control gate.

The second voltage is positive, in particular equal to the nominal power supply voltage Vdd in the case of an n-channel transistor.

In the case of a cell with p-channel transistor, operation remains symmetrical to the case of an n-channel transistor. The voltages applied are then referenced relative to Vdd and are negative relative to that reference, thus tending toward the zero voltage.

The example of an n-channel transistor is described below.

According to a preferred embodiment, the back control gate voltage is positive for programming and zero for the other operations.

In programming, the application of a positive voltage to the back control gate effectively makes it possible to reduce the threshold voltage of the transistor. The front control gate can then be supplied solely by the nominal read voltage Vdd. The programming voltages can thus be lowered, which considerably helps in the design of peripheral circuits (the word line control circuits no longer need to deliver high voltages, so that the need for circuits generating the overvoltage is eliminated) and reinforces the reliability of the cell and of the circuit in general.

Inasmuch as the stresses on the transistor are lowered, it is also possible to use smaller transistors.

According to a variant embodiment, a third voltage can be applied to the back control gate in a holding operation, in order to allow a better retention of the charges in the floating channel.

A zero or slightly negative voltage (a voltage close to Vdd in the case of a p-channel transistor) applied to the back control gate in holding operations makes it possible in particular to limit the leaks from the transistor.

Bearing in mind that, in the interests of simplicity, it is preferable to work with back control gate voltages equal to simple values (typically 0V, VDD, possibly VDD/2) which require nor or few circuits (that consume energy) to be available.

It will be remembered, however, that, in the case where the back control gate effect on the threshold voltage of the transistor does not have the desired amplitude, the voltage applied to the back control gate can still be modified to compensate for a "bad" ratio of thicknesses of the thin film, of the insulating layer, and of the gate dielectric layer, by using back control gate voltages different from the simple values mentioned hereinabove.

According to yet another variant, a fourth voltage, notably a positive voltage, is applied to the back control gate in a read operation. A read operation is, in effect, generally followed by a restore, that is to say a reprogramming. The application of a positive voltage to the back control gate in a read operation is then advantageous in that it makes it possible to reduce the voltages that then have to be applied to the front control gate.

It will have been understood from the forgoing that the invention makes it possible to advantageously use a memory cell that has an individualized back control gate. At the very least, only the cells arranged on one and the same line or one and the same column of a memory array share the same back control gate. A back gate line can thus be coupled to the back control gate of each of the cells along a line or a column.

In a manner known per se, a word line is coupled to the front control gate of each of the cells along a column of the memory array.

Provision is preferentially made for the back gate line to extend in parallel with the word line (the back control gate effectively assisting the front control gate in programming).

It is also possible to provide for the front control gate and the back control gate of a memory cell to be connected together which makes it possible to reduce the number of decoders needed. In particular, the word line of a column of a memory array can be linked to the back gate line parallel to it.

**Claims**

1. Method of controlling a DRAM memory cell consisting of an FET transistor on a semiconductor-on-insulator substrate comprising a thin film (3) of semiconductor material separated from a base substrate (1) by an isolating layer (2, BOX), the transistor having a channel (4) and two control gates, a front control gate (8, 11) being arranged on top of the channel (4) and separated from the latter by a gate dielectric (7, 10) and a back control gate (9, 12, 13, 17, 18) being arranged in the base substrate and separated from the channel (4) by the insulating layer (BOX), **characterized in that**, in a cell programming operation, the front control gate and the back control gate are used jointly by applying a first voltage to the front control gate and a second voltage to the back control gate, said first voltage being lower in amplitude than the voltage needed to program the cell when no voltage is applied to the back control gate.

2. Method according to Claim 1, in which the second voltage is positive.

3. Method according to either of Claims 1 and 2, in which, in a cell hold operation, a third voltage is applied to the back control gate.

4. Method according to Claim 3, in which the third voltage is negative or zero.

5. Method according to one of the preceding claims, in which, in a cell read operation, a fourth voltage is applied to the back control gate.

6. Method according to Claim 5, in which the fourth voltage is positive.

7. Method according to one of the preceding claims, in which the front control gate and the back control gate are connected together and a voltage that is identical to the voltage applied to the back control gate is applied to the front control gate.

# FIG. 1

## FIG. 2a

## FIG. 2b

FIG. 3

## FIG. 4a

## FIG. 4b

## FIG. 4c

## FIG. 4d

## FIG. 4e

## FIG. 4f

## FIG. 4g

## FIG. 4h

## FIG. 4i

## FIG. 4j

## FIG. 4k

Europäisches
Patentamt

European
Patent Office

Office européen
des brevets

**EUROPEAN SEARCH REPORT**

Application Number

EP 10 18 7012

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 233 454 A2 (TOSHIBA KK [JP]) 21 August 2002 (2002-08-21) * paragraphs [0043], [0 46], [ 144]; figures 3, 4, 7A, 7B, 26, 62 * ----- | 1-7 | INV. G11C11/404 H01L27/108 H01L29/423 H01L29/78 |
| X | US 2009/010056 A1 (KUO CHARLES C [US] ET AL KUO CHARLES C [US] ET AL) 8 January 2009 (2009-01-08) | 1 | |
| A | * paragraphs [0010], [0 11], [0 13]; figures 2-4 * ----- | 3-5 | |

TECHNICAL FIELDS
SEARCHED (IPC)

G11C
H01L

The present search report has been drawn up for all claims

| Place of search | Date of completion of the search | Examiner |
|---|---|---|
| The Hague | 17 January 2011 | Vidal Verdú, Jorge |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 18 7012

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2011

| Patent document cited in search report | | Publication date | Patent family member(s) | | Publication date |
|---|---|---|---|---|---|
| EP 1233454 | A2 | 21-08-2002 | CN | 1372323 A | 02-10-2002 |
| | | | CN | 1645618 A | 27-07-2005 |
| | | | JP | 3884266 B2 | 21-02-2007 |
| | | | JP | 2003086712 A | 20-03-2003 |
| | | | KR | 20020067974 A | 24-08-2002 |
| | | | TW | 525292 B | 21-03-2003 |
| | | | US | 2002114191 A1 | 22-08-2002 |
| US 2009010056 | A1 | 08-01-2009 | NONE | | |